# EUROPEAN PATENT SPECIFICATION

(11) **EP 2 529 605 B1**
(45) Date of publication and mention of the grant of the patent: **13.09.2017**
(21) Application number: 11736612.0
(22) Date of filing: 17.01.2011
(51) Int. Cl.: H05K 1/11

(54) **CONTACT PIECE OF GOLDEN FINGER, GOLDEN FINGER AND CONNECTOR COMPRISING THE GOLDEN FINGER**
KONTAKTSTÜCK FÜR EINEN GOLDENEN FINGER, GOLDENER FINGER UND STECKER MIT DEM GOLDENEN FINGER
PIÈCE DE CONTACT D'UNE LAME DE CONNECTEUR DORÉE, LAME DE CONNECTEUR DORÉE ET CONNECTEUR COMPRENANT LA LAME DE CONNECTEUR DORÉE

(30) Priority: 29.01.2010 CN 201020109297 U
(43) Date of publication of application: 05.12.2012
(73) Proprietor: BYD Company Limited, Shenzhen 518118 (CN); Shenzhen BYD Auto R&D Company Limited, Shenzhen, Guangdong 518118 (CN)
(72) Inventor: XIE, Bingbin, Shenzhen Guangdong 518118 (CN); PANG, Daocheng, Shenzhen Guangdong 518118 (CN)
(74) Representative: Gulde & Partner
(86) International application number: PCT/CN2011/070340
(87) International publication number: WO 2011/091730

(56) References cited:
- EP-A1- 1 632 886
- WO-A1-2006/038492
- CN-U- 201 657 501
- CN-Y- 201 066 956
- JP-A- 2004 095 872
- JP-A- 2005 093 706
- US-A- 4 586 789
- US-A1- 2009 233 459
- US-A1- 2010 096 165

## Description

### FIELD

The disclosure relates to a contact piece of a golden finger, a golden finger and a connector comprising the golden finger.

### BACKGROUND

The conventional connectors for connecting two circuit boards include board to board connectors, wire to board connectors, and flexible printed circuit board / flexible printed circuit board (FPC/FPC) connectors, in which the FPC/FPC connectors are widely used because of low cost. The golden finger adapted to the FPC/FPC connectors are widely used on flexible printed circuit boards.

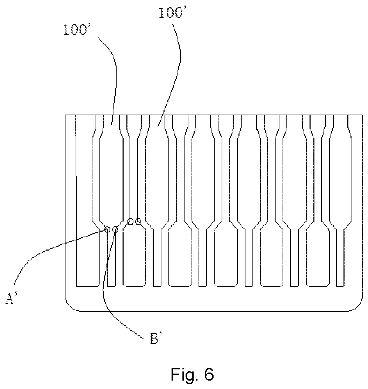

The contact pieces of the conventional golden finger are generally symmetric, as shown in Fig. 6, wherein the conventional contact piece 100' is axisymmetric, such that the symmetric contact pieces 100' of the golden finger have weak points A' and B' which are in the same horizontal line. Stress may be concentrated on the weak points when plugging or unplugging the good finger, so that the contact pieces may be easily broken, thus influencing reliability of the connection and reducing the life of the contact pieces.

US4586789A discloses electrode terminals provided on a liquid crystal display element for connection to an external drive circuit, which are arranged in two rows, and lead wires for exterior electrode terminals, which are collectively passed through space portions provided in the course of the row composed of interior electrode terminals.

US2010096165 (claiming priority of TWM353504U) discloses a golden finger for flexible printed circuitboard, comprising: a frame with a tail, being composed of a stiffening plate, a bottom substrate, a bottom copper layer, a cover layer, and a top copper layer while enabling the bottom copper layer to be formed with at least one first routing and at least one second routing, and enabling the top copper layer to be formed with at least one first pin and at least one second pin; at least one first via hole, each being filled with a conductive material and disposed at a position between its corresponding first pin and first routing for connecting the first pin to the first routing electrically; and at least one second via hole, each filled with a conductive material and being disposed at a position between the its corresponding second pin and second routing for connecting the second pin to the second routing electrically.

CN201066956Y relates to a terminal for flexible circuit boards, which comprises long fingers and short fingers which are mutually staggered and arranged. The free end of the long finger is longer than the free end of the short finger; wherein, the free end of the short finger extends to the direction away from a flexible circuit board body and forms a short inducing plate. With the structure, the force bearing area of the flexible circuit board terminal in a bending place is enlarged; the bending place of the terminal is not easy to be fractured after the force being dispersed.

US2009233459A1 discloses a wiring board that has a terminal section and a wiring section connected to the terminal section. The terminal section is configured so as to have a plurality of long connection terminals placed at predetermined intervals along a direction orthogonal to a direction in which the wiring board is to be inserted; and short connection terminals arranged between adjacent long connection terminals so as to be located behind the respective long connection terminals with respect to the direction of insertion. At least one adjacent pair consisting of a long connection terminal and a short connection terminal is short-circuited, and the length of the thus-short-circuited short connection terminal is made shorter than non-short-circuit short connection terminals.

### SUMMARY

According to a first aspect of the present disclosure, there is provided a contact piece of a golden finger comprising: a first main body segment; a second main body segment; and a transition segment connected between the first main body segment and the second main body segment in an up and down direction, wherein an upper edge and a lower edge of the transition segment are inclined with respect to a left and right direction respectively, wherein a first angle α is formed between the upper edge of the transition segment 3 and the left and right direction, and a second angle β is formed between the lower edge of the transition segment 3 and the left and right direction, wherein 30°<α<70°, and 30°<β<70°, wherein at least one of a left edge and a right edge of the transition segment 3 is a curve segment.

With the contact piece of the golden finger according to an embodiment of the present disclosure, by employing the asymmetric transition segment, the points at the left edge and the right edge of the contact piece on which the stress is concentrated may be staggered, so that the stress on the weakest points of the contact piece may be reduced, thus improving capability of the contact piece against the stress damage, ensuring reliability of the connection, and lengthening the service life of the contact piece.

According to a second aspect of the present disclosure, there is provided a golden finger comprising a plurality of contact pieces spaced apart from each other in a left and right direction. Each of the contact pieces comprises: a first main body segment; a second main body segment; and a transition segment connected between the first main body segment and the second main body segment in an up and down direction, wherein an upper edge and a lower edge of the transition segment are inclined with respect to the left and right direction respectively, wherein a first angle α is formed between the upper edge of the transition segment 3 and the left and right direction, and a second angle β is formed between the lower edge of the transition segment 3 and the left and right direction, wherein 30°<α<70°, and 30°<β<70°, wherein at least one of a left edge and a right edge of the transition segment 3 is a curve segment.

According to a third aspect of the present disclosure, there is provided a connector comprising: a substrate; and a golden finger comprising a plurality of contact pieces spaced apart from each other in a left and right direction. Each of the contact pieces comprises: a first main body segment; a second main body segment; and a transition segment connected between the first main body segment and the second main body segment in an up and down direction, wherein an upper edge and a lower edge of the transition segment are inclined with respect to the left and right direction respectively, wherein a first angle α is formed between the upper edge of the transition segment 3 and the left and right direction, and a second angle β is formed between the lower edge of the transition segment 3 and the left and right direction, wherein 30°<α<70°, and 30°<β<70°, wherein at least one of a left edge and a right edge of the transition segment 3 is a curve segment.

According to a fourth aspect of the present disclosure, there is provided a method for manufacturing a golden finger on a flexible printed circuit board comprising the golden finger, comprising: cutting a roll of copper foil into a plurality of copper foil sheets; laminating a layer of photosensitive material on a surface of the copper foil sheets; exposing a dry film portion through the sheltering of a pattern film; washing an unexposed dry film portion with a developing solution; removing the exposed copper by etching with an etching solution; peeling a remaining dry film portion with a peeling solution; laminating a layer of protective film on a surface of a circuit; hot pressing the layer of protective film to solidify the layer of protective film; laminating and reinforcing a back surface of the golden finger; hot pressing and reinforcing the back surface of the golden finger to solidify the back surface of the golden finger; plating a nickel layer on a surface of the golden finger; and forming a desired article by using a mould. Additional aspects and advantages of the embodiments of the present disclosure will be given in part in the following description, become apparent in part from the following description, or be learned from the practice of the embodiments of the present disclosure.

### BRIEF DESCRIPTION OF THE DRAWINGS

These and other aspects and advantages of the disclosure will become apparent and more readily appreciated from the following description taken in conjunction with the drawings in which:
Fig. 1 is a schematic view of a contact piece according to an embodiment of the present disclosure;
Fig. 2 is a schematic view of a contact piece according to another embodiment of the present disclosure;
Fig. 3 is a schematic view of a contact piece according to still another embodiment of the present disclosure;
Fig. 4 is a schematic view of a contact piece according to yet another embodiment of the present disclosure;
Fig. 5 is a schematic view of a connector according to an embodiment of the present disclosure, which shows a golden finger comprising a plurality of contact pieces according to an embodiment of the present disclosure; and
Fig. 6 is a schematic view of a golden finger with symmetric contact pieces in the prior art.

### DETAILED DESCRIPTION

Reference will be made in detail to embodiments of the present disclosure. The embodiments described herein with reference to the accompany drawings are only explanatory and illustrative, which are used to generally understand the present disclosure. The embodiments shall not be construed to limit the present disclosure. The same or similar elements or the elements having same or similar functions are denoted with like reference numerals throughout the description.

In the description, relative terms such as "right", "left", "lower", "upper", "horizontal", "vertical", "up" as well as derivative thereof should be construed to refer to the orientation as then described or as shown in the drawings under discussion. These relative terms are for convenience of description and do not require that the present disclosure be constructed or operated in a particular orientation. Terms concerning "connect" and the like, refer to a relationship wherein structures are secured or attached to one another either directly or indirectly through intervening structures, as well as both movable or rigid attachments or relationships, unless expressly described otherwise.

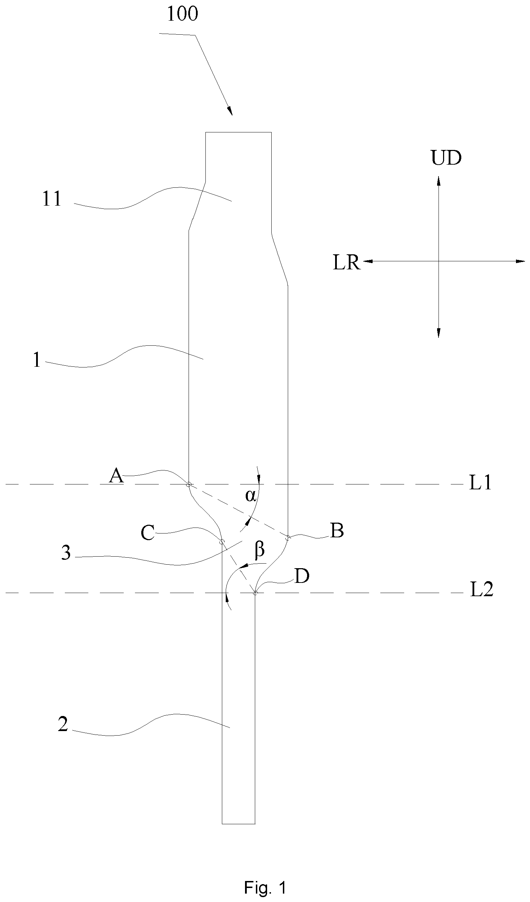

The contact piece 100 according to an embodiment of the present disclosure will be described below with reference to Fig. 1.

As shown in Fig. 1, the contact piece 100 comprises a first main body segment 1, a second main body segment 2 and a transition segment 3.

The transition segment 3 is connected between the first main body segment 1 and the second main body segment 2 in an up and down direction UD in Fig. 1 (i.e., a vertical direction), and an upper edge AB and a lower edge CD of the transition segment 3 are inclined with respect to a left and right direction LR in Fig. 1 (i.e., a horizontal direction) respectively. Therefore, the contact piece 100 according to the embodiment of the present disclosure may be referred to as an asymmetric contact piece which is asymmetric in the up and down direction UD.

The first main body segment 1 is configured to be connected with a circuit board, and the second main body segment 2 is used as a free end portion of the contact piece 100.

In the embodiment shown in Fig. 1, a size (i.e., width) of the first main body segment 1 in the left and right direction LR is greater than that of the second main body segment 2. For example, the width of the second main body segment 2 may be about 0.10-0.2 mm. Because the width of the second main body segment 2 is smaller than that of the first main body segment 1, the stress may tend to concentrate on points C and D of the contact piece 100 when plugging or unplugging the contact piece 100.

Because the upper edge AB and the lower edge CD of the transition segment 3 are inclined with respect to the left and right direction LR, stress concentrating on points A and B on the contact piece 100 are staggered in the up and down direction UD, and stress concentrating on points C and D are also staggered in the up and down direction UD. Therefore, when plugging or unplugging the contact piece 100, the stress on the contact piece 100 may be dispersed, the stress concentration is decreased, and consequently the contact piece 100 is not easy to be broken, thus improving reliability of the connection and lengthening the service life of the contact piece 100.

In some embodiments of the present disclosure, the first main body segment 1, the second main body segment 2, and the transition segment 3 of the contact piece 100 are integral. In this case, dividing the contact piece 100 into the first main body segment 1, the second main body segment 2, and the transition segment 3 is used for convenience of the description.

As shown in Fig. 1, in some embodiments of the present disclosure, a first angle α, i.e., the angel between the upper edge AB and a horizontal line L1, is formed between the upper edge AB of the transition segment 3 and the left and right direction LR. A second angle β, i.e., the angel between the lower edge CD and a horizontal line L2, is formed between the lower edge CD of the transition segment 3 and the left and right direction LR, wherein 30°<α<70°, and 30°<β<70°.

In the embodiment shown in Fig. 1, because the width of the second main body segment 2 is smaller than that of the first main body segment 1, β is greater than α. Therefore, the stress concentration on the contact piece 100 may be further reduced, and consequently the service life of the contact piece 100 may be lengthened.

As shown in Fig. 1, according to an example of the present disclosure, each of a left edge AC and a right edge BD of the transition segment 3 is a curve segment, thus further dispersing the stress on the contact piece 100. For example, the curve segment is formed by a plurality of arc segments, and each of the arc segments has a radius of about 0.10-0.15 mm.

As shown in Fig. 1, an upper end portion 11 (i.e., an end portion far away from the transition segment 3) of the first main body segment 1 is non-axisymmetrical. The length of the upper end portion 11 of the first main body segment 1 in the up and down direction UD may be determined according to particular applications. Therefore, the stress on the upper end portion 11 of the first main body segment 1 is dispersed, thus reducing the stress concentration on the upper end portion 11 of the first main body segment 1, and lengthening the service life of the contact piece 100.

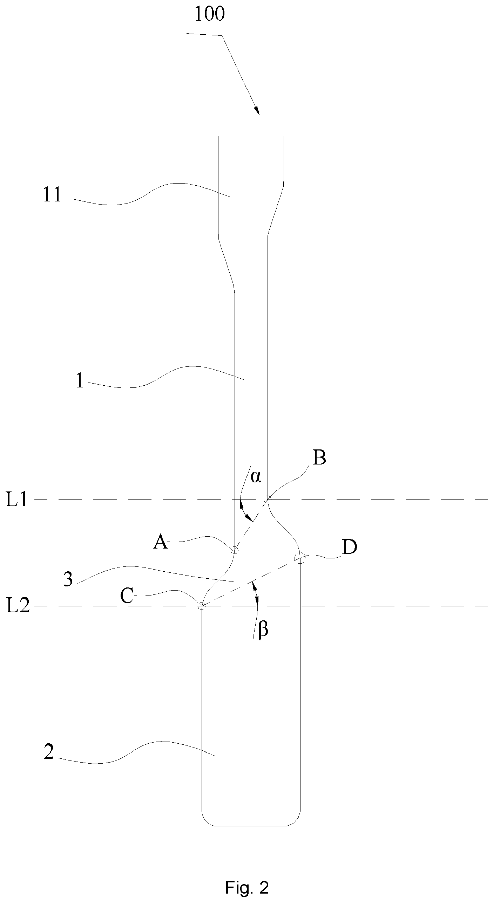

The contact piece 100 according to another embodiment of the present disclosure will be described below with reference to Fig. 2.

As shown in Fig. 2, the width of the first main body segment 1 is smaller than that of the second main body segment 2, so that the stress on the contact piece 100 may tend to concentrate on points A and B on the upper edge AB of the transition segment 3.

Similarly, because the upper edge AB and the lower edge CD of the transition segment 3 are inclined with respect to the left and right direction LR, thus dispersing the stress on the contact piece 100, and lengthening the service life of the contact piece 100.

Because the width of the first main body segment 1 is smaller than that of the second main body segment 2, β is less than α. In the embodiment shown in Fig. 2, an upper end portion 11 of the first main body segment 1 is also non-axisymmetrical.

The inclination direction of the upper edge AB in the embodiment shown in Fig. 2 is opposite to that of the upper edge AB in the embodiment shown in Fig. 1, and the inclination direction of the lower edge CD in the embodiment shown in Fig. 2 is opposite to that of the lower edge CD in the embodiment shown in Fig. 1. Other structures of the contact piece 100 in the embodiment shown in Fig. 2 may be identical with those of the contact piece 100 in the embodiment shown in Fig. 1, and therefore the detailed description thereof is omitted here.

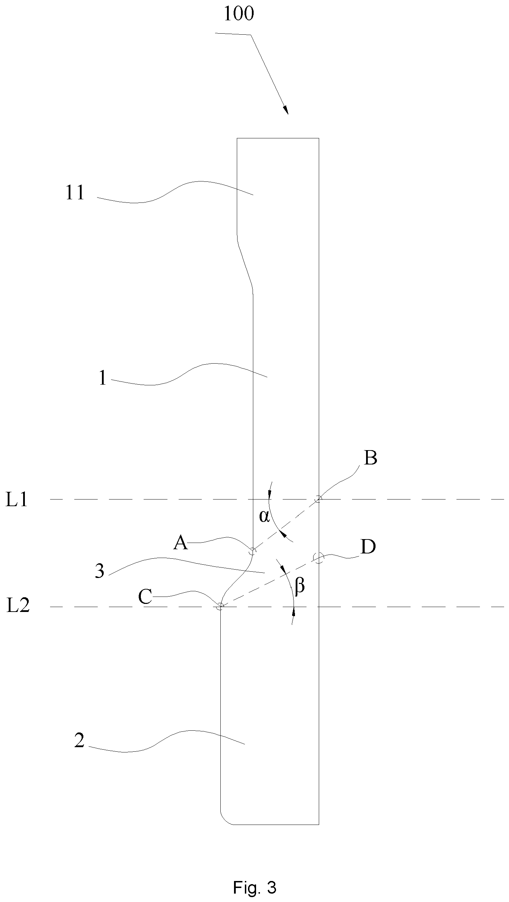

Fig. 3 shows a contact piece 100 according to still another embodiment of the present disclosure. As shown in Fig. 3, a left edge AC of the transition segment 3 is a curve segment, and a right edge BD thereof is a straight line segment. The width of the second main body segment 2 is greater than that of the first main body segment 1, and an upper end portion 11 of the first main body segment 1 is non-axisymmetrical.

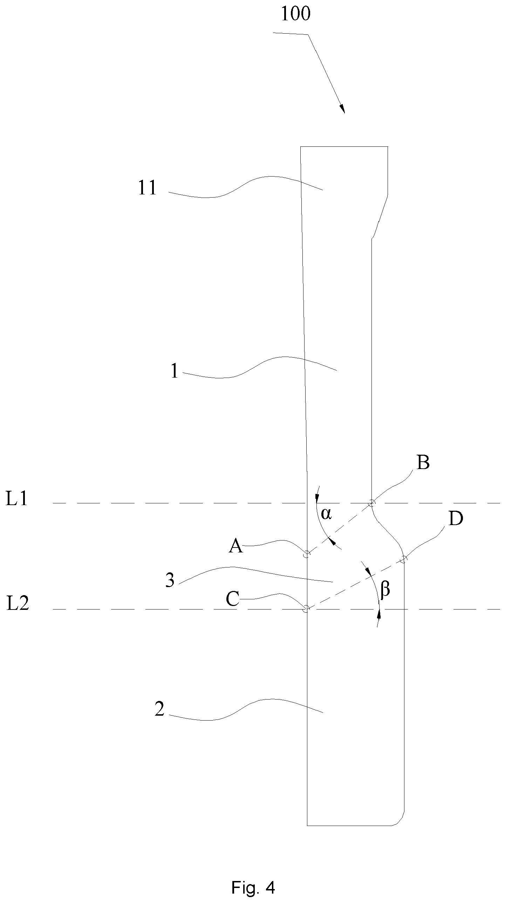

Fig. 4 shows a contact piece 100 according to yet another embodiment of the present disclosure. As shown in Fig. 4, a left edge AC of the transition segment 3 is a straight line segment, and a right edge BD thereof is a curve segment. The width of the second main body segment 2 is greater than that of the first main body segment 1, and an upper end portion 11 of the first main body segment 1 is non-axisymmetrical.

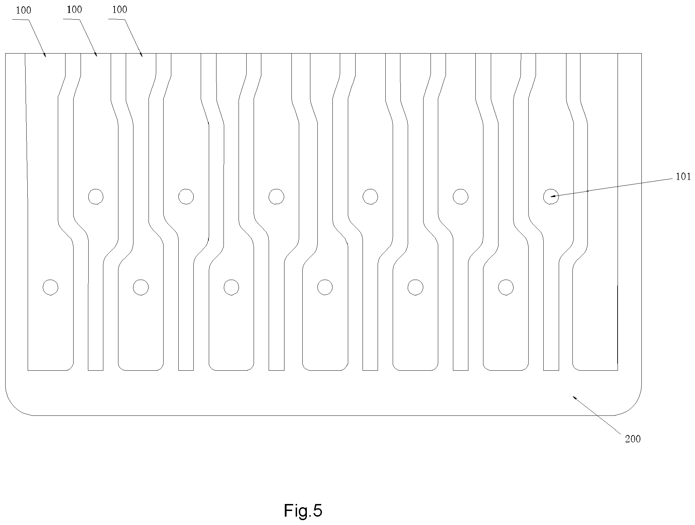

A golden finger according to an embodiment of the present disclosure will be described below with reference to Fig. 5. The golden finger according to the embodiment of the present disclosure comprises a plurality of contact pieces 100 spaced apart from each other in the left and right direction LR, wherein the plurality of contact pieces 100 may be those described in the above embodiments.

In a specific example of the present disclosure, as shown in Fig. 5, the leftmost contact piece 100 is the one described in the embodiment shown in Fig. 4, the rightmost contact piece 100 is the one described in the embodiment shown in Fig. 3, and the contact pieces 100 between the leftmost contact piece 100 and the rightmost contact piece 100 are those shown in Figs. 1-2, wherein the contact pieces 100 shown in Fig. 1 and the contact pieces 100 shown in Fig. 2 are disposed alternately.

With the golden finger according to an embodiment of the present disclosure, the stress on each contact piece 100 is dispersed, thus lengthening the service life of each contact piece 100.

The connector according to an embodiment of the present disclosure will be described below with reference to Fig. 5.

The connector according to an embodiment of the present disclosure comprises a substrate 200 and a golden finger disposed on the substrate 200. The golden finger may be the one described according to the above embodiment. A contact point 101 on each contact piece 100 of the golden finger is configured to be contacted with a corresponding connector.

With the connector according to an embodiment of the present disclosure, the stress on each contact piece 100 of the golden finger is dispersed, and consequently each contact piece 100 may be difficult to be broken, thus lengthening the service life of each contact piece 100.

A method for manufacturing a golden finger on a flexible printed circuit board comprising the golden finger according to an embodiment of the present disclosure comprises the following step:
cutting a roll of copper foil into a plurality of copper foil sheets;
laminating a layer of photosensitive material on a surface of the copper foil sheets;
exposing a dry film portion through the sheltering of a pattern film;
washing an unexposed dry film portion with a developing solution;
removing the exposed copper by etching with an etching solution;
peeling a remaining dry film portion with a peeling solution;
laminating a layer of protective film on a surface of a circuit;
hot pressing the layer of protective film to solidify the layer of protective film;
laminating and reinforcing a back surface of the golden finger;
hot pressing and reinforcing the back surface of the golden finger to solidify the back surface of the golden finger;
plating a nickel layer on a surface of the golden finger; and
forming a desired article by using a mould.

The method for preparing the flexible printed circuit board is well known to those skilled in the art, and the consequently detailed description thereof is omitted here. In this embodiment, the golden finger is used in a FPC/FPC connector.

### TEST

In order to test the bending performance of the golden finger, the golden finger according to an embodiment of the present disclosure and a conventional golden finger having a symmetric structure as shown in Fig. 6 are plugged into a connector, and then pulled out respectively. The plugging and unplugging are repeated until a crack occurs with the golden finger, and the plugging and unplugging times are recorded in Table 1.

**Table 1**

| Golden Finger | plugging and unplugging Times |
|---|---|
| Embodiment Of The Present Disclosure | 348 |
| Conventional example | 78 |

It can be seen from Table 1 that, the golden finger according to an embodiment of the present disclosure may be plugged and unplugged 348 times, while the conventional golden finger having a symmetric structure can be only plugged and unplugged 78 times.

Therefore, the stress on the golden finger according to an embodiment of the present disclosure may be effectively dispersed, and consequently the golden finger is not easy to be broken, thus prolonging the service life of the golden finger.

Reference throughout this specification to "an embodiment", "some embodiments", "an example" or "a specific example" means that a particular feature, structure, material, or characteristic described in connection with the embodiment or example is included in at least one embodiment or example of the disclosure. Thus, the appearances of the phrases such as "in some embodiments" or "in a specific example" in various places throughout this specification are not necessarily referring to the same embodiment or example of the disclosure. Furthermore, the particular features, structures, materials, or characteristics may be combined in any suitable manner in one or more embodiments or examples.

## Claims

1. A contact piece (100) of a golden finger, comprising:
a first main body segment (1);
a second main body segment (2); and
a transition segment (3) connected between the first main body segment (1) and the second main body segment (2) in an up and down direction (UD), wherein an upper edge and a lower edge of the transition segment (3) are inclined with respect to a left and right direction (LR) respectively,
wherein a first angle α is formed between the upper edge of the transition segment (3) and the left and right direction (LR), and a second angle β is formed between the lower edge of the transition segment (3) and the left and right direction (LR), wherein 30°<α<70°, and 30°<β<70°,
**characterized in that** at least one of a left edge and a right edge of the transition segment (3) is a curve segment.

2. The contact piece (100) of claim 1, wherein the first main body segment (1), the second main body segment (2), and the transition segment (3) are integral.

3. The contact piece (100) according to any one of claims 1 to 2, wherein each of the left edge and the right edge of the transition segment (3) is a curve segment.

4. The contact piece (100) according to any one of claims 1 to 2, wherein one of the left edge and the right edge of the transition segment (3) is a curve segment, and the other is a straight line segment.

5. The contact piece (100) according to claim 3, wherein the curve segment is formed by a plurality of arc segments.

6. The contact piece (100) according to claim 5, wherein each of the arc segments has a radius of about 0.10-0.15 mm.

7. The contact piece (100) according to any one of claims 1 to 6, wherein an upper end portion of the first main body segment (1) is non-axisymmetrical.

8. A golden finger comprising a plurality of contact pieces (100) according to any one of claims 1 to 7 spaced apart from each other in a left and right direction (LR).

9. A connector, comprising:
a substrate (200); and
a golden finger according to claim 8.

10. A method for manufacturing a golden finger according to claim 8 on a flexible printed circuit board, comprising:
cutting a roll of copper foil into a plurality of copper foil sheets;
laminating a layer of photosensitive material on a surface of the copper foil sheets;
exposing a dry film portion through the sheltering of a pattern film;
washing an unexposed dry film portion with a developing solution;
removing the exposed copper by etching with an etching solution;
peeling a remaining dry film portion with a peeling solution;
laminating a layer of protective film on a surface of a circuit;
hot pressing the layer of protective film to solidify the layer of protective film;
laminating and reinforcing a back surface of the golden finger;
hot pressing and reinforcing the back surface of the golden finger to solidify the back surface of the golden finger;
plating a nickel layer on a surface of the golden finger; and
forming a desired article by using a mould.

## Patentansprüche

1. Ein Kontaktstück (100) für einen goldenen Finger, aufweisend:
ein erstes Hauptkörpersegment (1);
ein zweites Hauptkörpersegment (2); und
ein Übergangssegment (3), das zwischen dem ersten Hauptkörpersegment (1) und dem zweiten Hauptkörpersegment (2) in einer Aufwärts- und Abwärtsrichtung (UD) verbunden ist, wobei ein oberer Rand und ein unterer Rand des Übergangsegments (3) bezüglich jeweils einer linken und rechten Richtung (LR) geneigt sind,
wobei ein erster Winkel α zwischen dem oberen Rand des Übergangsegments (3) und der linken und rechten Richtung (LR) ausgebildet ist und ein zweiter Winkel β zwischen dem unteren Rand des Übergangselements (3) und der linken und rechten Richtung (LR) ausgebildet ist, wobei 30°<α<70° ist und 30°<β<70° ist,
**dadurch gekennzeichnet, dass** zumindest einer eines linken Rands und eines rechten Rands des Übergangsegments (3) ein Kurvensegment ist.

2. Das Kontaktstück (100) nach Anspruch 1, wobei das erste Hauptkörpersegment (1), das zweite Hauptkörpersegment (2) und das Übergangssegment (3) einstückig sind.

3. Das Kontaktstück (100) nach einem der Ansprüche 1 bis 2, wobei jeder des linken Rands und des rechten Rands des Übergangsegments (3) ein Kurvensegment ist.

4. Das Kontaktstück (100) nach einem der Ansprüche 1 bis 2, wobei einer des linken Rands und des rechten Rands des Übergangsegments (3) ein Kurvensegment ist und der andere ein gerades Liniensegment ist.

5. Das Kontaktstück (100) nach Anspruch 3, wobei das Kurvensegment von einer Vielzahl von Bogensegmenten ausgebildet wird.

6. Das Kontaktstück (100) nach Anspruch 5, wobei jedes der Bogensegmente einen Radius von etwa 0,10-0,15 mm aufweist.

7. Das Kontaktstück (100) nach einem der Ansprüche 1 bis 6, wobei ein oberer Endabschnitt des ersten Hauptkörpersegments (1) nicht achsensymmetrisch ist.

8. Ein goldener Finger, aufweisend eine Vielzahl von Kontaktstücken (100) nach einem der Ansprüche 1 bis 7, die in einer linken und rechten Richtung (LR) voneinander beabstandet sind.

9. Ein Stecker, aufweisend:
ein Substrat (200); und
einen goldenen Finger nach Anspruch 8.

10. Ein Verfahren zur Herstellung eines goldenen Fingers nach Anspruch 8 auf einer flexiblen Leiterplatte, aufweisend:
Schneiden einer Rolle aus Kupferfolie in eine Vielzahl von Kupferfolienblättern;
Laminieren einer Schicht aus lichtempfindlichem Material auf eine Oberfläche der Kupferfolienblätter;
Belichten eines trockenen Filmabschnitts durch den Schutz eines strukturierten Films;
Waschen eines unbelichteten trockenen Filmabschnitts mit einer Entwicklungslösung;
Entfernen des belichteten Kupfers durch Ätzen mit einer Ätzlösung;
Ablösen eines verbleibenden trockenen Filmabschnitts mit einer Ablöselösung;
Laminieren einer Schutzfilmschicht auf eine Oberfläche einer Schaltung;
Heißpressen der Schutzfilmschicht zum Verfestigen der Schutzfilmschicht;
Laminieren und Verstärken einer Rückseite des goldenen Fingers;
Heißpressen und Verstärken der Rückseite des goldenen Fingers zum Verfestigen der Rückseite des goldenen Fingers;
Plattieren einer Nickelschicht auf einer Oberfläche des goldenen Fingers; und
Ausbilden eines gewünschten Artikels unter Verwendung einer Form.

## Revendications

1. Une pièce de contact (100) d'une lame de connecteur dorée, comprenant :
un premier segment de corps principal (1) ;
un second segment de corps principal (2) ; et
un segment de transition (3) connecté entre le premier segment de corps principal (1) et le second segment de corps principal (2) dans une direction vers le haut et vers le bas (UD), un bord supérieur et un bord inférieur du segment de transition (3) étant inclinés par rapport à une direction vers la gauche et vers la droite (LR), respectivement,
un premier angle α étant formé entre le bord supérieur du segment de transition (3) et la direction vers la gauche et vers la droite (LR) et un second angle β étant formé entre le bord inférieur du segment de transition (3) et la direction vers la gauche et vers la droite (LR), 30°<α<70° et 30°<β<70°,
**caractérisée en ce qu'**au moins l'un d'un bord gauche et d'un bord droit du segment de transition (3) est un segment de courbe.

2. La pièce de contact (100) selon la revendication 1, dans laquelle le premier segment de corps principal (1), le second segment de corps principal (2) et le segment de transition (3) sont d'un seul tenant.

3. La pièce de contact (100) selon l'une des revendications 1 à 2, dans laquelle chacun du bord gauche et du bord droit du segment de transition (2) est un segment de courbe.

4. La pièce de contact (100) selon l'une des revendications 1 à 2, dans laquelle l'un du bord gauche et du bord droit du segment de transition (3) est un segment de courbe et l'autre bord est un segment de ligne droite.

5. La pièce de contact (100) selon la revendication 3, dans laquelle le segment de courbe est formé par une pluralité de segments d'arc.

6. La pièce de contact (100) selon la revendication 5, dans laquelle chacun des segments d'arc a un rayon d'environ 0,10-0,15 mm.

7. La pièce de contact (100) selon l'une des revendications 1 à 6, dans laquelle une partie d'extrémité supérieure du premier segment de corps principal (1) n'est pas axisymétrique.

8. Une lame de connecteur dorée, comprenant une pluralité de pièces de contact (100) selon l'une des revendications 1 à 7 qui sont espacées les unes des autres dans une direction vers la gauche et vers la droite (LR).

9. Un connecteur, comprenant :
un substrat (200) ; et
une lame de connecteur dorée selon la revendication 8.

10. Un procédé de fabrication d'une lame de connecteur dorée selon la revendication 8 sur une carte de circuit imprimé souple, comprenant :
couper un rouleau de film de cuivre en une pluralité de feuilles de film de cuivre ;
stratifier une couche de matière photosensible sur une surface des feuilles de film de cuivre ;
exposer une partie de film sec par la protection d'un film à motif ;
laver une partie de film sec non exposée à l'aide d'une solution révélatrice ;
enlever le cuivre exposé par une gravure à l'aide d'une solution de gravure ;
décoller une partie de film sec restante à l'aide d'une solution de décollement ;
stratifier une couche de film protecteur sur une surface d'un circuit ;
presser à chaud la couche de film protecteur de manière à solidifier la couche de film protecteur ;
stratifier et renforcer une surface arrière de la lame de connecteur dorée ;
presser à chaud et renforcer la surface arrière de la lame de connecteur dorée de manière à solidifier la surface arrière de la lame de connecteur dorée ;
plaquer une couche de nickel sur une surface de la lame de connecteur dorée ; et
former un article désiré en utilisant une moule.
